# EUROPEAN PATENT APPLICATION

(11) **EP 2 945 275 A1**
(43) Date of publication of application: **18.11.2015**
(21) Application number: 15167755.6
(22) Date of filing: 14.05.2015
(51) Int. Cl.: H02M 7/5387, H02M 1/00

(54) **DIAGNOSTICS AND CONTROL CIRCUIT**

(30) Priority: 15.05.2014 GB 201408672
(71) Applicant: Control Techniques Ltd, Newtown, Powys SY16 3BE (GB)
(72) Inventor: Hart, Simon David, Powys, SY16 3BE (GB)
(74) Representative: Morrall, Jonathan Ian McLachlan

(57) **Abstract**

A circuit for self-diagnosis and control comprising a plurality of processing devices (11,12,13) each having a voltage supply (14,15,16), the processing devices (11,12,13) being arranged to communicate with one another and being arranged to be electrically isolated from each processing device (11,12,13) having a different voltage supply (14,15,16).

## Description

This invention relates to self-diagnostics and control. It is particularly suitable for, but by no means limited to aiding self-diagnostics and control in inverter drive circuits.

### Background

In a typical two-level inverter drive circuit, certain portions of the circuit operate at high voltage and certain portions operate at a lower voltage that is usually considered safe for user interaction.

Optical isolation is a well-known technique for ensuring user safety. However, the use of isolation increases the product cost and introduces signal delays which vary with batch of manufacture and temperature. Allowance must therefore be made for the worst case delays which in turn reduces the control performance.

Some prior art inverter drive systems employ a two processor solution where one of the processors is referenced to a negative dc bus supply and the other is referenced to a safe user voltage, typically ELV (extremely low voltage). The processor which is referenced to the negative dc bus supply requires further opto-isolation for the upper gate drives and would also require isolation if any upper IGBT Vce monitoring, or upper line shunt based current sensing, was required. The processor which is referenced to the negative dc bus supply provides a non-isolated interface with the three lower IGBT gate drives and may also provide a non-isolated interface with the brake IGBT gate drive and the lower line shunt current feedback.

There is an increasing desire for improved drive fault self-diagnostics and higher control performance which has created a need for more circuit data and control signals to be available to the self-diagnosis and control system. With known systems, an increased number of circuit data and control signals being subject to self-diagnostics requires a different approach to isolation and general circuit organisation.

### Summary

According to a first aspect there is provided a circuit as defined in Claim 1 of the appended claims. Thus there is provided a circuit for self-diagnosis and control comprising a plurality of processing devices each having a voltage supply, the processing devices being arranged to communicate with one another and being arranged to be electrically isolated from each processing device having a different voltage supply.

Optionally, the processing devices are coupled in serial with one another.

Optionally, wherein the processing devices are coupled in a ring.

Optionally, wherein at least one processing device is arranged to operate at an ELV supply level.

Optionally, wherein the electrical isolation comprises opto-isolation.

Optionally, wherein the processing devices are arranged to communicate bi-directionally with one another.

Optionally, wherein the processing devices are arranged to communicate messages comprising data for self-diagnosis and control.

Optionally, wherein the messages comprise timing and circuit parameter information.

Optionally, wherein each processing device is arranged to output a message on a transmit output when communicating to the other processing devices.

Optionally, wherein transmit and receive ports are coupled by an OR gate so that messages received from an upstream processing device are passed through to a downstream processing device.

Optionally, wherein a message output by each processing device is appended to data being transmitted between the processing devices.

Optionally, wherein the processing devices are arranged so that messages received from an upstream processing device are echoed to a downstream processing device.

Optionally, wherein each processing device adds the message based on messages received from other processing devices at the receive port and/or sensor and circuit data received from the circuit under self-diagnosis and control.

Optionally, wherein one of the processing devices is arranged to operate as a master device and each of the at least one other devices are arranged to operate as slave devices.

Optionally, wherein the master device operates at an ELV supply level.

Optionally, wherein the master processing device is arranged to determine a total communication delay between the processing devices based on the time between transmitting and receiving the synchronistion pulse of a communication frame.

Optionally, wherein the master processing device is arranged to provide information to each slave device so as to mitigate the total communication delay in a circuit under self-diagnosis and control.

Optionally, wherein at least one of the slave processing devices is arranged to modify control signals of the circuit under self-diagnosis and control based on the total communication delay.

Optionally, the circuit further comprising at least one of the processing devices comprising an input for receiving a signal indicative of at least one parameter of a circuit under self-diagnosis and control; and at least one of the processing devices comprising an output for providing a control signal of the circuit under self-diagnosis and control.

Optionally, the circuit wherein the circuit under self-diagnosis and control comprises an inverter.

Optionally, wherein the circuit under self-diagnosis and control comprises an AC motor drive circuit.

According to a second aspect there is provided a method as defined in claim 11. Thus there is provided method of controlling a circuit for self-diagnosis and control as claimed in any preceding claim, the method comprising the steps of: a first processing device providing a communication frame to a downstream processing device, the communication frame comprising: a synchronisation pulse, a circuit information portion, and a message portion.

Optionally, the method further comprising receiving the communication frame at a downstream device

Optionally, the method further comprising the downstream device appending a message within the communication frame.

Optionally, the method further comprising providing the communication frame including the synchronisation pulse, circuit information and messages to a further downstream device.

Optionally, the method wherein the circuit for self-diagnosis and control comprises a plurality of processing devices, the method further comprising carrying out the receiving the communication frame, the providing to a further downstream device and optionally the appending a message steps at each of the downstream processing devices.

Optionally, the method wherein the further downstream device is the first processing device.

Optionally, the method wherein the last downstream device transmits the communication frame to the first processing device.

Optionally, the method wherein the appended messages comprise timing and circuit parameter information.

Optionally, the method further comprising the first processing device calculating a total communication delay between the processing devices based on the time between transmitting and receiving the synchronisation pulse of a communication frame.

Optionally, the method further comprising the first processing device providing information to each downstream processing device so as to mitigate the total communication delay in a circuit under self-diagnosis and control.

Optionally, the method further comprising at least one of the downstream processing devices modifying control signals of a circuit under self-diagnosis and control based on the total communication delay.

Optionally, the method wherein the first processing device is a master processing device.

According to a third aspect there is provided a computer readable medium as defined in claim 15.

With all the aspects, preferable and optional features are defined in the dependent claims.

### Brief Description of the Drawings

Embodiments will now be described, by way of example only, and with reference to the drawings in which:
Figure 1 illustrates a diagnostics and control circuit according to an embodiment;
Figure 2 illustrates message flow according to an embodiment;
Figure 3 illustrates message flow according to an embodiment;
Figure 4 illustrates a method according to an embodiment; and
Figure 5 illustrates a system according to an embodiment.

In the figures, like elements are indicated by like reference numerals throughout.

### Overview

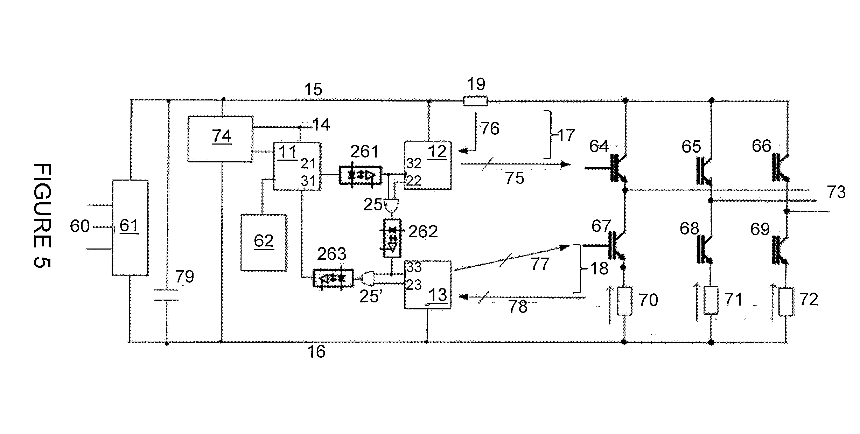

In overview, a user interface to a circuit under self-diagnosis and control ("The Circuit") is provided. The Circuit may take the form of a power converter (drive) used to control an AC motor which comprises a rectifier, a dc bus capacitor and an inverter (as illustrated in figure 5). The inverter comprises a number of semiconductor switches in two groups, one group being connected to a negative dc bus supply and the other group being connected to a positive dc bus supply. A plurality of processing devices interface with circuits that share a common reference with each processing device. Each processing device and shared reference is isolated from the other references in The Circuit. By providing communication between each processing device, preferably in a loop configuration, timing, switching and other information for use by The Circuit may be communicated between the processing devices. Each processing device may sample parameters of The Circuit and output a message containing information indicative of the parameters received so that each processing device may be aware of operating characteristics and status of different parts of The Circuit. One of the processing devices, a master device, may determine the communication delay between the processing devices and make allowances for the delay when formulating messages to send to the other slave processing devices. The master device provides an increased amount of Circuit diagnostic and control information and may operate at an ELV (extremely low voltage) supply level therefore providing a safe user interface to diagnostic and control information.

### Detailed Description

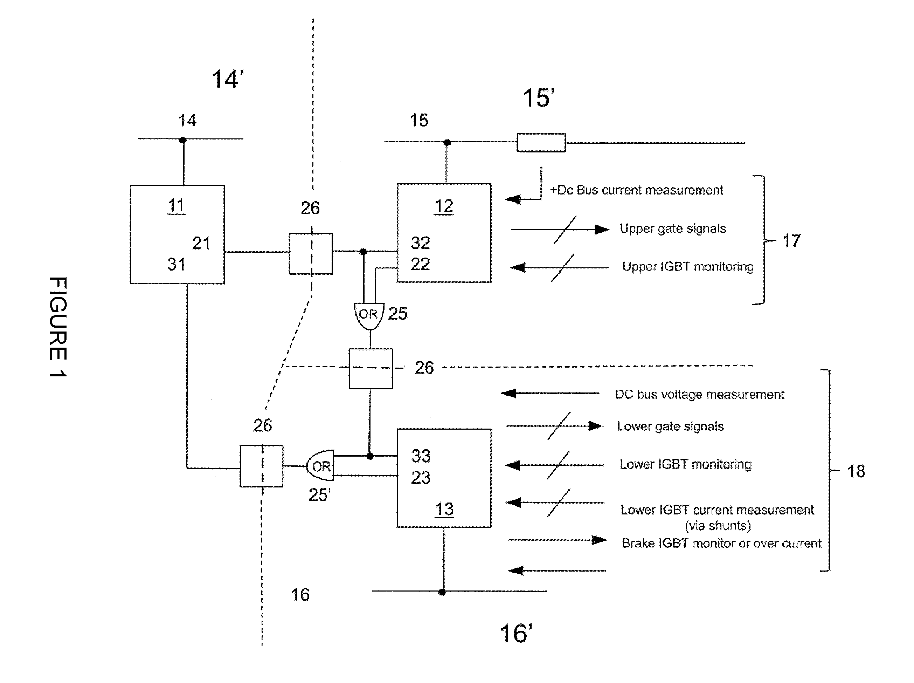

Turning to figure 1, an embodiment is shown comprising three processing devices 11, 12 and 13. The processing devices may comprise a processor, an FPGA, a PLD or any other programmable devcie. Each processing device may comprise a timer. Other pluralities of processing devices may be used. Each processing device interfaces with circuitry that shares a common reference voltage with that processing device, for example, ELV (14), +DC (15) and -DC (16). There may be two or more processing devices operating at the same reference voltage.

Each processing device may provide one or more signals to and/or receive one or more signals from The Circuit (at the same reference as the respective processing device). For example, in Figure 1, it can be seen that processing device 12 may be coupled to signals 17 and processing device 13 may be coupled to signals 18. In this embodiment signals 17 and 18 comprise the gate drive signals of IGBTs, bus voltage measurement, current measurement (for example via shunt resistors such as shunt 19) and other monitoring signals. Signals 17 and 18 may comprise any other signals as would be useful to be received by or from The Circuit for diagnosis and control. Processing devices 12 and 13, therefore, in this embodiment, have knowledge of parameters of The Circuit, and may send control signals to portions of The Circuit.

Each of the processing devices 11, 12 and 13 are communicatively coupled to one another, preferably in a loop configuration. Such a loop configuration allows each processing device (node) to add information to the data that is communicated therebetween as will be explained. Each processing device may utilise different voltage levels for inter-processing device communication, such as but not limited to a 5v or a 3.3v logic high level.

Bi-directional communication is provided between each processing device by way of transmit ports (21, 22, 23) and receive ports (31, 32, 33) on each device respectively. The transmit and receive ports may be serial or parallel. As would be understood, the transmit port of one processing device feeds into the receive port of a downstream device that it is communicatively coupled with. The communication may be asynchronous or synchronous.

As can be seen from Figure 1, each processing device is isolated from a portion of The Circuit that operates at a different reference voltage level. This ensures user safety. The isolation may be achieved by way of opto-isolators 26 in the transmit/receive path(s). Areas 14', 15', 16' represent the isolated reference voltages of each processing device and associated components. As well as providing isolation, the isolators may also provide conversion between differing logic levels of the various processing devices that reside in the different reference voltage levels of The Circuit.

The isolation devices may also provide buffering of communicated data for data accuracy and to mitigate any noise in the underlying system. The buffering can also cater for embodiments where there are many processors communicatively coupled to one another and hence the communication path in any one voltage reference area is of a significant length. Additional buffers may be placed in the communication path in the case of particularly noisy environments and/or for long communication paths and/or for data integrity. In other embodiments, separate parts of the circuit under test may be positioned in different enclosures. This may include different enclosures for different voltage references of the circuit. Inter-enclosure buffering may be desirable which could be provided by the isolators and/or by way of additional buffers placed in the communication path. Such buffering may include communication protocols such as LVDS (low-voltage differential signalling) or other differential communication to aid with noise mitigation such as RS485. Optionally, inter-enlcoure communication may comprise optical communication.

One of the processing devices (preferably a device that is operating at an ELV reference voltage level) is considered to be a master device, and all other devices are considered to be slave devices.

The master processing device typically provides the (ELV) user interface. In the embodiment where the Circuit is an inverter motor drive, the master device may provide gating signals that are derived from a motor control algorithm that has user inputs (such as speed reference for example). Therefore, the master device is typically the processor referenced to the ELV as this is the processor that provides the safest user interface. The master device sends out a communication frame (a set of data comprising one or more messages) from transmit port 21 which flows via isolation to a receive port (32) of a downstream slave processing device (12 in the embodiment of figure 1). Processing device 12 receives the communication frame from the master device and may append its own message to the data communicated within the communication frame by way of transmit port 22. The next processing device may act in a similar manner as illustrated in relation to processing device 13 in Figure 1.

In order that messages sent from the master device are able to be passed through to a next device (i.e. propagate to all other downstream processing devices), the transmit and receive ports of the slave devices may be OR'ed together (25, 25'). As would be understood, this allows each slave device to receive messages from upstream processing devices, and if desired, append its own message to the end of the message stream without having to also recreate the original message. One or more of the OR gates may also provide additional buffering of the communication data. Alternatively, a processor node may echo out the data that has been received which would negate the need for an OR gate between the transmit and receive ports of that particular processor. As can be seen from Figure 1, the message flow enables messages from each subsequent processing device to propagate to the next. The flow returns to the master processing device where the master device may react to messages that have been appended by the slave devices. The master device may therefore adjust settings, timings and/or other control parameters and/or signals in subsequent message(s) sent to the slave devices. For example, when The Circuit is an inverter, the master processing device may provide inverter switching information by way of a communication frame (messages) sent from transmit port 21 every inverter switching period.

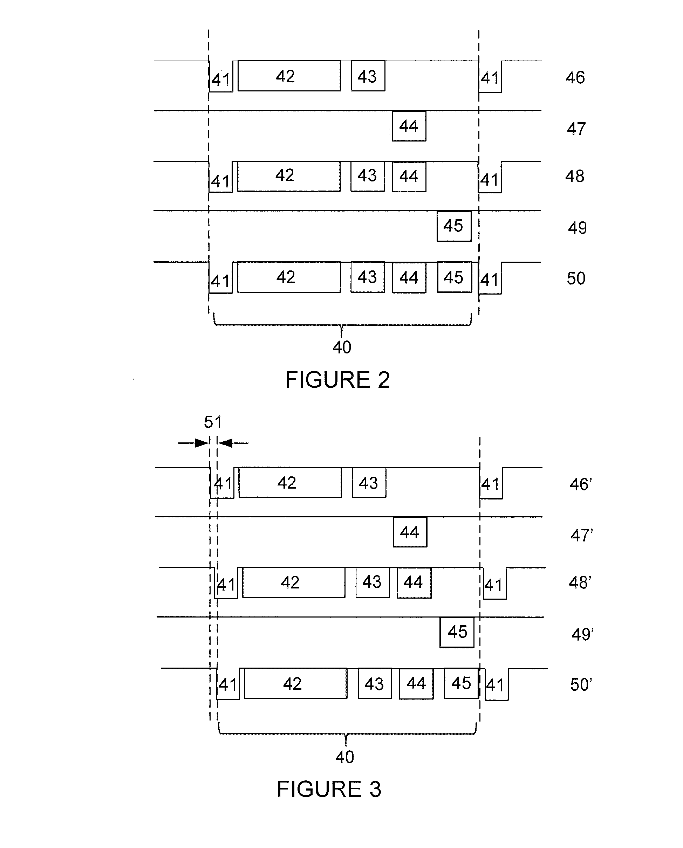

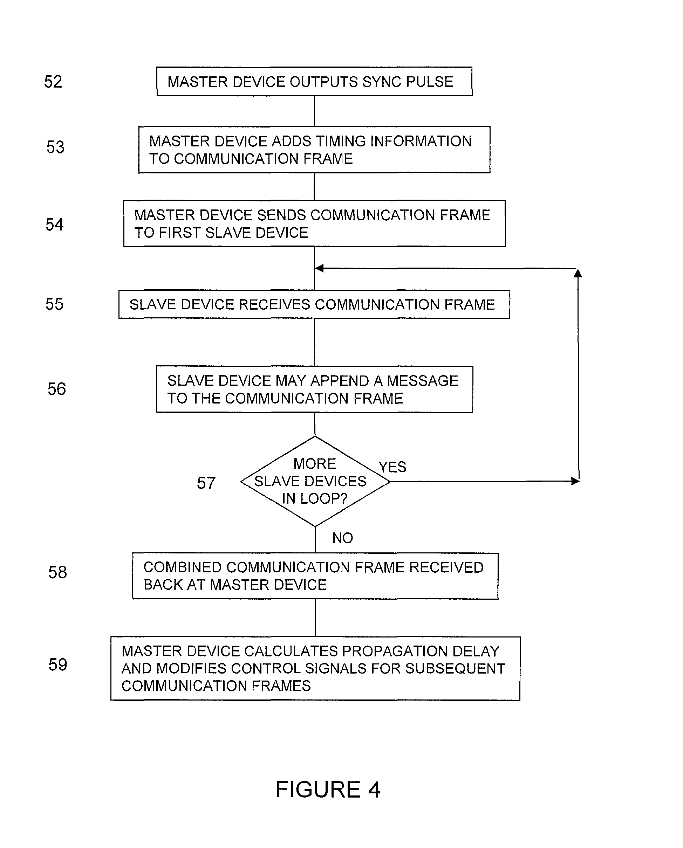

Turning to Figure 2 and also referring to method steps of figure 4, the inter-processing device message protocol will now be described. Figure 2 assumes the ideal situation where there is no propagation delay in the communication loop. The communication frame 40 comprises a synchronisation pulse 41 (which is preferably a low pulse) and which is output from the transmit port of the master processing device (see plot 46 of figure 2 and step 52 of figure 4). The synchronisation pulse may be used to synchronise the timers in each processing device with the timer within the master processing device. The synchronisation pulse may also be used to trigger the start of a PWM switching period of, for example, IGBT gate drive signals, and a current sampling point. Brake IGBT switching (as would be understood) could also be triggered from the synchronisation pulse if desired.

Within portion 42 of communication frame 40, the master processing device may add information pertaining to timing and/or control signals of The Circuit (step 53 of figure 4). In the embodiment where The Circuit is an inverter, gate drive timing information sent within portion 42 may be used by the slave processors to provide gate drive pulses and other control signals such as control of a brake IGBT as would be understood by the skilled person. The timing information sent by the master processing device may comprise local timer values or modulation and angle information to be used by the slave processing devices to produce inverter gate signals. Again, in the embodiment where The Circuit is an inverter, portion 42, which comprises the PWM timing information, should be received by relevant slave processing devices before the next PWM period starts in order to prepare their timers ready to control their respective IGBTs.

Further, the master processing device may also add a first message (portion 43) to the communication frame. The first message may contain data to address the slave processors, data to control the slave processors and information regarding switching period duration of an inverter circuit under diagnostics and control for example. Depending on the length of the message, the first message may be spread over more than one communication frame portion 43 which may span more than one communication frame 40.

Each communication frame 40 is sent (step 54 of figure 4) at an appropriate time for The Circuit. For example, for an inverter, each communication frame is sent at the beginning an inverter switching period. Timing information sent during one inverter switching period is utilised by the slave processing devices during the next switching period.

Plot 47 of figure 2 illustrates activity at the transmit port of the next slave device from the master device (in this embodiment, at slave device 12). It is clear that the waveform originating from the master device is received at the receive port 32 of device 12 (step 55 of figure 4), therefore this is omitted from figure 2. Slave device 12 may then append a second message (step 56 of figure 4) in portion 44 of communication frame 40 which is OR'd with the originating waveform from the master device by OR gate 25. Portion 44 is positioned chronologically after portion 43 thereby retaining visibility of the first message in portion 43 to any subsequent slave devices. The second message appended by slave device 12 may comprise sensor information, parameter information of The Circuit or any other information available to the slave device that is relevant to operation of the self-diagnosis and control system.

Plot 48 of figure 2 illustrates the waveform that is received at slave device 13 which is the next slave device downstream from device 12. In this embodiment, step 57 of figure 4 is answered in the positive as there are other slave devices left in the communication loop. As is shown, slave device 13 receives the original waveform from the master device plus the second message (if one is present) that has been appended by the previous slave device (12) - a repeat of step 55 of figure 4. In the same manner as device 12, device 13 may add its own message as a third message in communication frame portion 45 as shown in plot 49 (a repeat of step 56 of figure 4). Subsequent to appending the third message the whole communication frame is transmitted back to the master device (as there are no other slave devices in the communication loop) where it is received on receive port 31 as shown in plot 50 (step 58 of Figure 4). As shown, plot 50 comprises a combined final communication frame having a sync pulse 41 as well as timing information portion 42 and message portions 43, 44 and 45. As can be seen a bi-directional inter-processing device link is provided by the inter-processing device communication loop.

Depending on the length of each message (for example the return type as would be understood), in the same manner as the first message, any other message may be spread over more than one communication frame portion which may span more than one communication frame 40. Any slave device may omit to append a message if appropriate.

A CRC may be used with any portion of the communication frame to mitigate noise in the communication lines.

The format of portion 42 and message portions 43, 44 and 45 of the communication frame 40 may be in the form of <id or address><data payload><CRC>.

Figure 3 illustrates waveforms (46', 47', 48', 49', 50') identical to those of figure 2 except that a propagation delay within the communication loop is shown and taken into account. As will be appreciated, there will be a delay from when the master device first outputs the low going edge of the synchronisation pule 41 at its transmit output 21, to when the same pulse is received at the receive port 31 of the master device (shown as time period 51). This delay may be calculated and used to modify control and/or timing signals of the slave processing devices in a subsequent communication frame (step 59 of figure 4). For example, this delay may be used to modify inverter dead times (for example in the embodiment of figure 5), owing to the fact that the synchronisation pulses to the local timers of the slave devices will also be delayed.

Figure 5 illustrates an embodiment where the user interface is controlling and diagnosing an inverter coupled to an AC motor. The drive is supplied from a three phase AC supply 60. The AC supply is rectified 61 to produce the positive and negative DC bus supply lines (15, 16 respectively). The drive also comprises a DC bus capacitor 79 as would be understood. A DC to DC converter 74 is connected between the DC bus supply lines which produces an ELV supply 14 that is isolated from the DC bus supply lines. The ELV supply 14 is used by processor 11 as also shown in figure 1. Processor 11 is coupled to a user interface 62. The user interface may comprise a display and user input device such as a keyboard or keypad. Both processor 11 and the user interface 62 are coupled to the ELV supply 14 and are therefore safe for users to interact with.

Processor 12 is referenced to the positive dc bus supply 15 (as also shown in figure 1) and is fed from a dc to dc converter (not shown) which is supplied from the DC bus supply in the same manner as the ELV supply for processor 11. Processor 12 is connected to processor 11 by an isolator comprising opto-coupler 261. The opto-couplers of figure 5 are also shown in figure 1 as reference 26.

Processor 13 is referenced to the negative dc bus supply 16 (as also shown in figure 1) and is fed from a dc to dc converter (not shown) which is supplied from the DC bus supply in the same manner as the respective supplies for processors 11 and 12.

Processor 13 is connected to processor 11 by an isolator comprising opto-coupler 262. Processor 11 is connected to processor 13 by an isolator comprising opto-coupler 263. The communication network between each of the three processors was described previously with reference to figure 1.

As already explained in relation to figure 1, processor 12 may receive switching information from processor 11 through the serial communication network and use this information to determine when to switch IGTB1 (64), IGTB 3 (65) and IGTB 5 (66), considered to be the 'upper' IGBT devices.

In the same manner, processor 13 may receive switching information from processor 11 through the serial communication network and use this to determine when to switch IGTB2 (67), IGTB4 (68) and IGBT6 (69), considered to be the 'lower' IGBT devices.

Processor 12 may transmit and/or receive circuit status and/or parameter information or signals indicative thereof via signals 17 as shown in figures 1 and 5 (a subset of signals 17 is shown in Figure 5 for clarity comprising upper gate signals 75 and positive DC bus current information 76). For example, current measurement information 76 may be collected from the Positive DC shunt resistor 19. This information may be passed through the serial communication network to processor 11 and may be displayed on the user interface and/or used by processor 11 for subsequent timing calculations and/or other parameter changes.

Processor 13 may transmit and/or receive circuit status and/or parameter information or signals indicative thereof via signals 18 as shown in figures 1 and 5 (a subset of signals 18 is shown in Figure 5 for clarity comprising lower gate signals 77 and lower IGBT current measurement 78). For example, current measurement information 78 or signals indicative thereof may be collected from lower shunt resistors (70, 71, 72). This information may be passed through the serial communication network to processor 11 and may be displayed on the user interface and/or used by processor 11 for subsequent timing calculations and/or other parameter changes.

As would be understood, IGBT devices 64 to 69 form an inverter which converts the dc bus supply 15, 16 to a 3-phase output 73. The IGBTs form two groups, the "uppers" being IGBTs 64, 65, 66 which are connected to the positive DC shunt 19 and the positive DC bus supply 15. The "lowers" being IGBTs 67, 68, 69 which are connected to the negative DC bus supply 16. The lower shunt resistors (70, 71, 72) measure current whenever a respective lower IGBT (67, 68, 69) is turned on (when it is connecting the respective output phase to the negative dc bus supply 16).

If a fault condition occurs, such as a lower current shunt resistor 70, 71, 72 providing a signal indicative of too much current being passed out through the three phase output, processor 11 can determine this from the information sent from processor 13 via the communication path. Processor 11 can subsequently stop the switching of the inverter IGBTs by communicating through the serial communication network. Processor 11 can then instruct the user interface to display a message to alert the user to the fault condition. Such communication and information interchange between the various processors can be used for any parameter and/or status information of signals 17 and 18 that is available to any of the processors.

In relation to the delay time 51 which may be calculated by processor 11 based on the communication propagation information gleaned from the communication path, in the embodiment of figure 5, as would be understood, each of the three phase inverter output voltage 73 is produced by alternatively connecting the output to the positive dc supply 15 and then the negative dc supply 16 in each switching period by way of IGBTs 64 to 69. The ratio in time between the connection to the positive dc supply 15 and connection to the negative dc supply 16 allows a degree of control on the resulting average output phase voltage of output 73.

The connection to the positive dc supply 15 is controlled by the or a processor that is referenced to the positive bus supply (processor 12). The connection to the negative dc supply 16 is controlled by the or a processor that is referenced to the negative bus supply (processor 13). A fault will occur if both a connection to the positive dc supply and a connection to the negative supply were to take place at the same time as this would provide a low impedance path (or short circuit) between the positive and negative dc supplies 15, 16. In order to protect against this fault, an interval of no connection (or dead-time) is inserted between each IGBT switched connection. This may also be used to compensate for delays in the processor, communication and control circuits and the semiconductor switches (64 to 69). If each connection is controlled by a different processor, there will be an additional variation in the connection periods caused by the time to receive and sample the timing information sent by the master processor (processor 11, the ELV processor in this embodiment).

Such a variation - the delay time 51, can be controlled and taken into account by the master processor when the communication loop delay is measured.

The various methods described above may be implemented by a computer program. The computer program may include computer code arranged to instruct one or more processors to perform the functions of one or more of the various methods described above. The computer program and/or the code for performing such methods may be provided to an apparatus, such as a processor, FPGA or other processing device on a computer readable medium or computer program product. The computer readable medium could be, for example, an electronic, magnetic, optical, electromagnetic, infrared, or semiconductor system, or a propagation medium for data transmission, for example for downloading the code over the Internet. Alternatively, the computer readable medium could take the form of a physical computer readable medium such as semiconductor or solid state memory, magnetic tape, a removable computer diskette, a random access memory (RAM), a read-only memory (ROM), a rigid magnetic disc, and an optical disk, such as a CD-ROM, CD-R/W or DVD.

As described, increased self-diagnosis and control information is made available to a user interface operating at a safe voltage level. Further benefits of the system as described herein include:
- A reduced number of gate opto-isolators (this reduces cost and reduces communication delay) over prior art systems.
- Increased diagnostic information can be collected without requiring additional isolation.
- Provide more IO at useful reference voltage references.
- The system may be extended to other topologies (multi-level converters etc.) by way of adding in more processing devices in other voltage reference levels.
- Increased scope for protecting the circuit under diagnosis and control by way of increasing the robustness and reliability of the end product.
- Removal of the opto-isolators from the upper gate drives of prior systems to reduce the allowance needed for the variance of the timing system and increase the control performance.

## Claims

1. A circuit for self-diagnosis and control comprising:
a plurality of processing devices each having a voltage supply, the processing devices being coupled in a ring;
the processing devices being arranged to communicate with one another and being arranged to be electrically isolated from each processing device having a different voltage supply.

2. The circuit as claimed in claim 1 wherein the processing devices are coupled in serial with one another.

3. The circuit as claimed in any preceding claim wherein the processing devices are arranged to communicate bi-directionally with one another.

4. The circuit as claimed in any preceding claim wherein the processing devices are arranged to communicate messages comprising data for self-diagnosis and control, and optionally wherein the messages comprise timing and circuit parameter information.

5. The circuit as claimed in any preceding claim wherein each processing device is arranged to output a message on a transmit output when communicating to the other processing devices, and optionally wherein a message output by each processing device is appended to data being transmitted between the processing devices.

6. The circuit as claimed in any of claims 1 to 5 wherein the processing devices are arranged so that messages received from an upstream processing device are echoed to a downstream processing device.

7. The circuit as claimed in claim 5 wherein each processing device adds the message based on messages received from other processing devices at the receive port and/or sensor and circuit data received from the circuit under self-diagnosis and control.

8. The circuit as claimed in any preceding claim wherein one of the processing devices is arranged to operate as a master processing device and each of the at least one other devices are arranged to operate as slave devices, and optionally wherein the master processing device operates at an ELV supply level.

9. The circuit as claimed in claim 8 wherein the master processing device is arranged to determine a total communication delay between the processing devices based on the time between transmitting and receiving the synchronisation pulse of a communication frame, and optionally wherein the master processing device is arranged to provide information to each slave device so as to mitigate the total communication delay in a circuit under self-diagnosis and control, and further optionally wherein at least one of the slave processing devices is arranged to modify control signals of the circuit under self-diagnosis and control based on the total communication delay.

10. The circuit as claimed in any preceding claim further comprising at least one of the processing devices comprising an input for receiving a signal indicative of at least one parameter of a circuit under self-diagnosis and control; and at least one of the processing devices comprising an output for providing a control signal of the circuit under self-diagnosis and control.

11. A method of controlling a circuit for self-diagnosis and control as claimed in any preceding claim, the method comprising the steps of:
a first processing device providing a communication frame to a downstream processing device, the communication frame comprising:
a synchronisation pulse;
a circuit information portion; and
a message portion.

12. The method as claimed in claim 11 further comprising receiving the communication frame at a downstream device, and optionally further comprising the downstream device appending a message within the communication frame.

13. The method of claim 11 or 12 further comprising providing the communication frame including the synchronisation pulse, circuit information and messages to a further downstream device, and optionally wherein the circuit for self-diagnosis and control comprises a plurality of processing devices, the method further comprising carrying out the receiving the communication frame, the providing to a further downstream device and optionally the appending a message steps at each of the downstream processing devices.

14. The method as claimed in claim 13 wherein the further downstream device is the first processing device, and optionally wherein the last downstream device transmits the communication frame to the first processing device.

15. A computer readable medium comprising instructions that when executed by a processing device, cause the processing device to carry out the method of any of claims 11 to 14.
